# EUROPÄISCHE PATENTANMELDUNG

(11) **EP 2 993 249 A1**
(43) Veröffentlichungstag der Anmeldung: **09.03.2016**
(21) Anmeldenummer: 15178395.8
(22) Anmeldetag: 27.07.2015
(51) Int. Cl.: C23C 10/28, C23C 16/06, C23C 16/56, B22F 3/105

(54) **OBERFLÄCHENGLÄTTUNG VON GENERATIV HERGESTELLTEN BAUTEILEN UND ENTSPRECHEND HERGESTELLTE BAUTEILE EINER STRÖMUNGSMASCHINE**

(30) Priorität: 08.09.2014 DE 102014217858
(71) Anmelder: MTU Aero Engines AG, 80995 München (DE)
(72) Erfinder: Liebl, Christian, 85461 Bockhorn (DE); Blumenschein, Karl, 85244 Röhrmoos (DE); Schlothauer, Steffen, 85253 Erdweg (DE); Heß, Thomas, 81541 München (DE)

(57) **Zusammenfassung**

Die vorliegende Erfindung betrifft ein Verfahren zur Herstellung von Bauteilen, insbesondere Bauteilen von Strömungsmaschinen, wie Flugzeugtriebwerken, wobei zur Herstellung des Bauteils (1) zumindest teilweise ein generatives Verfahren verwendet wird, wobei mindestens ein Oberflächenbereich (3) des generativ hergestellten Teils des Bauteils (1) mit einer Glättungsschicht (2) versehen wird, die durch Dampfphasenabscheidung abgeschieden wird. Die Erfindung betrifft weiterhin ein entsprechend hergestelltes Bauteil einer Strömungsmaschine.

## Beschreibung

### GEBIET DER ERFINDUNG

Die vorliegende Erfindung betrifft ein Verfahren zur Herstellung eines Bauteils einer Strömungsmaschine, insbesondere eines Flugzeugtriebwerks, unter Verwendung eines generativen Herstellungsverfahrens sowie ein entsprechend hergestelltes Bauteil.

### STAND DER TECHNIK

Generative Herstellverfahren, bei denen ein Bauteil schichtweise aus einem Pulverwerkstoff aufgebaut wird, wie Pulverauftragsschweißen, selektives Laserschmelzen, selektives Lasersintern, selektives Elektronenstrahlschmelzen, selektives Elektronenstrahlsintern und dergleichen sind interessante Herstellungsverfahren für Bauteile von Strömungsmaschinen, wie stationären Gasturbinen oder Flugzeugtriebwerken, da mit diesen Verfahren schwierig zu verarbeitende Werkstoffe, die beispielsweise schwer zu gießen sind, eingesetzt werden können und zudem endkonturnahe Bauteile hergestellt werden können, sodass aufwändige Nachbearbeitungen durch spanabhebende Verfahren, wie Fräsen, eingespart werden können.

Allerdings gibt es bei generativ hergestellten Bauteilen die Problematik, dass teilweise die Oberflächengüte hinsichtlich der Rauheit den Anforderungen, insbesondere für einen Einsatz in Strömungsmaschinen, nicht genügt. So können Bauteile mit zu rauen Oberflächen an Strömungsflächen, also an Flächen an denen ein Fluid vorbei strömt, einen zu hohen Strömungswiderstand aufweisen oder die Strömungsverhältnisse durch unerwünschte Verwirbelung des Fluidstroms negativ beeinflussen. Außerdem sind teilweise raue Oberflächen für die Umgebungsbedingungen ungeeignet, da raue Oberflächen einem erhöhten Oxidations- und/oder Korrosionsangriff ausgesetzt sein können.

Somit kann es erforderlich sein, entsprechende Oberflächen nachzuarbeiten, um die Rauheit zu verringern, was jedoch einen hohen Aufwand mit sich bringt.

### OFFENBARUNG DER ERFINDUNG

### AUFGABE DER ERFINDUNG

Aufgabe der vorliegenden Erfindung ist es deshalb, ein Verfahren zur Herstellung von Bauteilen einer Strömungsmaschine bereitzustellen, welches in effizienter Weise mit möglichst geringem Aufwand die Herstellung von Bauteilen mit geeigneten Eigenschaftsprofilen und insbesondere mit Oberflächen mit geringer Rauheit ermöglicht, wobei möglichst variabel eine Vielzahl von unterschiedlichen Werkstoffen zur Herstellung des Bauteils Verwendung finden soll.

### TECHNISCHE LÖSUNG

Diese Aufgabe wird gelöst durch ein Verfahren mit den Merkmalen des Anspruchs 1 sowie ein Bauteil mit den Merkmalen des Anspruchs 11. Vorteilhafte Ausgestaltungen sind Gegenstand der abhängigen Ansprüche.

Die Erfindung schlägt vor, bei zumindest teilweise generativ hergestellten Bauteilen zumindest an einem Oberflächenbereich des zumindest generativ hergestellten Teils des Bauteils, an dem dies erforderlich ist, eine Glättungsschicht vorzusehen, die durch Gasphasenabscheidung abgeschieden wird, um so eine glatte Oberfläche zu erzielen. Damit wird auf einfache Weise ermöglicht, generativ hergestellte Bauteile mit ausreichend glatten Oberflächen bereitzustellen, die für Strömungsmaschinen dadurch geeignet sind, dass zum einen die Strömungsflächen, an denen Fluid vorbei strömt, ausreichend glatt sind, um eine negative Beeinflussung der Strömung zu vermeiden, und zum anderen der Korrosionsangriff aufgrund einer zu rauen Oberfläche vermieden wird.

Ein entsprechendes Bauteil, das mit einer Glättungsschicht versehen wird, kann ganz oder teilweise generativ hergestellt sein, und zwar mit unterschiedlichen bekannten Verfahren zur generativen Herstellung von Bauteilen, wie selektives Laserschmelzen, selektives Lasersintern, selektives Elektronenstrahlschmelzen, selektives Elektronenstrahlsintern und Pulverauftragsschweißen.

Insbesondere kann der gesamte Bereich des Bauteils, der generativ hergestellt worden ist, mit einer entsprechenden Glättungsschicht versehen werden. Allerdings ist es auch möglich, nur einen Teil des Bauteils, also auch nur einen Teil des generativ hergestellten Teils des Bauteils, mit einer Glättungsschicht zu versehen oder das gesamte Bauteil kann mit einer Glättungsschicht versehen werden.

Die Glättungsschicht kann durch verschiedene Gasphasenabscheidungstechniken abgeschieden werden, wie beispielsweise physikalische oder chemische Gasphasenabscheideverfahren. Physikalische Gasphasenabscheideverfahren (PVD physical vapour deposition) können beispielsweise thermisches Verdampfen, Sputtern, Laserstrahlverdampfen oder Elektronenstrahlverdampfen umfassen, wobei einzelne physikalische Gasphasenabscheideverfahren plasmaunterstützt erfolgen können, wie beispielsweise plasmaunterstütztes Sputtern. Auch bei der chemischen Gasphasenabscheidung (CVD chemical vapour deposition) kann eine Plasmaunterstützung eingesetzt werden (PECVD plasma-enhanced chemical vapour deposition).

Die Glättungsschicht kann mit einer Dicke von 5 µm bis 200 µm, insbesondere 10 µm bis 100 µm aufgebracht werden, sodass mit einer derartigen Glättungsschicht durch das generative Herstellungsverfahren eingebrachte Oberflächenrauheiten am Bauteil ausgeglichen werden können und die abgeschiedene Glättungsschicht selbst eine ausreichend glatte Oberfläche aufweisen kann. Durch eine ausreichend dicke Glättungsschicht kann der Glättungseffekt bewirkt werden, während durch die Minimierung der Dicke der Glättungsschicht der Herstellungsaufwand reduziert werden kann.

Das Material der Glättungsschicht kann unterschiedlich zu dem oder den Materialen sein, aus denen das Bauteil aufgebaut ist. Allerdings, kann es vorteilhaft sein , wenn die Glättungsschicht ein oder mehrere chemische Elemente umfasst, die auch im Werkstoff, aus dem das Bauteil gefertigt ist (Grundwerkstoff), welches mit der Glättungsschicht beschichtet werden soll, enthalten sind. Dadurch kann die Haftung der Glättungsschicht auf dem Bauteil verbessert bzw. gewährleistet werden. Die Glättungsschicht kann aus einem Metall oder einer Legierung oder einer chemischen Verbindung gebildet sein. Bei einer Strömungsmaschine, bei welcher für entsprechende Bauteile, wie Strömungskanalbegrenzungen, Laufschaufeln, Leitschaufeln und dergleichen als Grundwerkstoffe Legierungen, wie Nickel - Legierungen, Nickel - Basis - Superlegierungen, Titan - Legierungen und dergleichen eingesetzt werden, können insbesondere Metalle, die auch zu einem deutlichen Anteil in den Grundwerkstoffen des zu beschichtenden Bauteils enthalten sind, für die Glättungsschicht verwendet werden. Beispielsweise kann für ein Bauteil, dessen Grundwerkstoff aus einer Nickel - Basislegierung, wie IN718 mit Nickel, Chrom, Eisen, Molybdän, Titan, Aluminium und weiteren geringfügigen Bestandteilen für die Glättungsschicht eine Aluminiumschicht gewählt werden.

Nach dem Aufbringen der Glättungsschicht kann das Bauteil mit der Glättungsschicht einer Wärmebehandlung unterzogen werden, insbesondere einer Diffusionsglühung, sodass Material aus der Glättungsschicht in den Grundwerkstoff eindiffundieren und/oder Material aus dem Grundwerk in die Glättungsschicht diffundieren kann, sodass sich eine gute Haftfestigkeit der Glättungsschicht und ein Ausgleich der chemischen Zusammensetzung ergeben. Auf der Glättungsschicht kann eine weitere zusätzliche Funktionsschicht abgeschieden werden. Durch die Aufbringung einer Glättungsschicht können Bauteile erzeugt werden, deren Oberfläche eine mittlere Rauheit Rₐ kleiner oder gleich 10 µm, insbesondere kleiner oder gleich 5 µm aufweisen. Die mittlere Rauheit wird durch den mittleren Abstand eines Messpunkts auf der Oberfläche zu einer Mittellinie bezüglich der Oberfläche bestimmt. Die Mittellinie schneidet dabei das tatsächliche Oberflächenprofil so, dass die Summe der Profilabweichungen bezogen auf die Mittellinie minimal wird. Entsprechend ist die mittlere Rauheit das arithmetische Mittel der Abweichung von der Mittellinie.

### KURZBESCHREIBUNG DER FIGUREN

Die beigefügten Zeichnungen zeigen in rein schematischer Weise in
- Figur 1: eine seitliche Querschnittansicht eines generativ hergestellten Bauteils und in
- Figur 2: einen teilweisen Querschnitt durch eine Oberfläche des generativ hergestellten Bauteils nach Aufbringung einer Glättungsschicht.

### AUSFÜHRUNGSBEISPIEL

Weitere Vorteile, Kennzeichen und Merkmale der vorliegenden Erfindung werden bei der nachfolgenden detaillierten Beschreibung eines Ausführungsbeispiels deutlich. Allerdings ist die Erfindung nicht auf dieses Ausführungsbeispiel beschränkt.

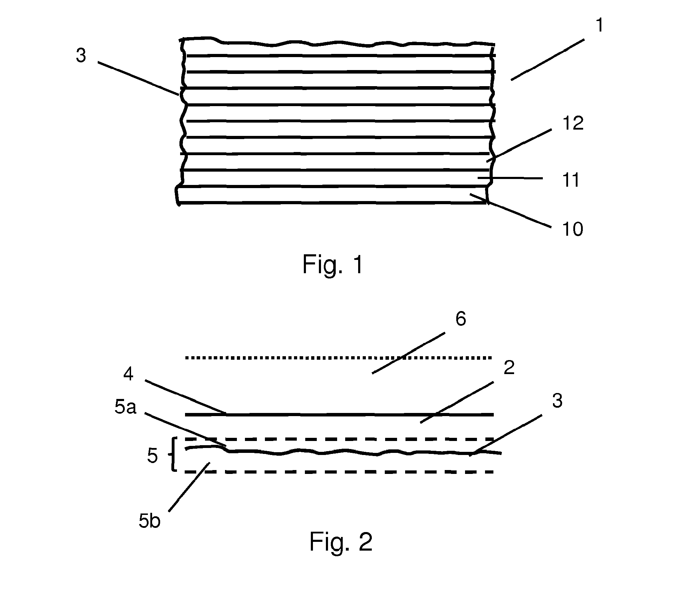

Die Figur 1 zeigt in einer rein schematischen Querschnittansicht ein Bauteil 1, welches aus einer Vielzahl von übereinander angeordneten Schichten 10, 11 und 12 aufgebaut ist. Beispielsweise kann das Bauteil 1 durch selektives Laserschmelzen aufgebaut sein, bei dem Pulverschichten entsprechend der zu erzeugenden Geometrie des Bauteils 1 selektiv durch einen Laserstrahl aufgeschmolzen werden, der sich über die Pulverschicht bewegt, sodass nach dem Erstarren der Schmelze die entsprechende Pulverschicht mit einer darunterliegenden Schicht des Bauteils verbunden ist, sodass Schicht für Schicht das Bauteil 1 aufgebaut werden kann.

Ein derartig aufgebautes Bauteil 1 kann eine relativ raue Oberfläche 3 aufweisen, die beispielsweise für den Einsatz in Strömungsmaschinen ungeeignet ist, da die raue Oberfläche 3 die Strömungsverhältnisse bei Flächen, an denen ein Fluid entlang strömt, negativ beeinflussen kann und zum anderen die raue Oberfläche anfällig für Korrosionsangriffe sein kann.

Entsprechend wird die Oberfläche 3 des Bauteils 1 gemäß der Figur 2 mit einer Glättungsschicht 2 versehen, die die Rauheiten der rauen Oberflächenschicht 3 des Bauteils 1 ausgleicht und eine glatte Oberfläche 4 bereitstellt. Die Glättungsschicht 2 wird durch Dampfphasenabscheidung eines entsprechenden Glättungsschichtmaterials abgeschieden, beispielsweise durch chemische Dampfphasenabscheidung (CVD chemical vapour deposition). Zusätzlich kann das Bauteil 1 zusammen mit der Glättungsschicht 2 nach Aufbringen derselben einer zusätzlichen Wärmebehandlung unterzogen werden, sodass Material aus der Glättungsschicht 2 in den Grundwerkstoff des Bauteils 1 diffundiert um dort eine Diffusionsteilschicht 5b zu bilden, während Material aus dem Grundwerkstoff des Bauteils 1 in die Glättungsschicht 2 diffundieren kann, um dort die Diffusionsteilschicht 5a zu bilden, sodass an der Grenzfläche zwischen Glättungsschicht 2 und Bauteil 1 eine Diffusionsschicht entsteht, die eine gute Haftung der Glättungsschicht 2 ermöglicht.

Das Bauteil 1 kann mit der glatten Oberfläche 4 direkt eingesetzt werden, beispielsweise als Begrenzungselement des Strömungskanals in einer stationären Gasturbine oder eines Flugzeugtriebwerks oder als Lauf - oder Leitschaufel einer entsprechenden Strömungsmaschine.

Darüber hinaus besteht die Möglichkeit, dass auf der glatten Oberfläche 4 nach Aufbringung der Glättungsschicht 2 eine weitere Funktionsschicht 6 aufgebracht wird, wie beispielsweise eine Korrosionsschutzschicht oder eine Wärmedämmschicht oder dergleichen.

Obwohl die vorliegende Erfindung anhand des Ausführungsbeispiels detailliert beschrieben wurde, ist es für den Fachmann klar, dass die Erfindung nicht auf dieses Ausführungsbeispiel beschränkt ist, sondern dass Abwandlungen in der Weise möglich sind, dass einzelne Merkmale oder andersartige Kombinationen von Merkmalen verwirklicht werden können, solange der Schutzbereich der beigefügten Ansprüche nicht verlassen wird. Die vorliegende Offenbarung schließt sämtliche Kombinationen der vorgestellten Einzelmerkmale mit ein.

## Patentansprüche

1. Verfahren zur Herstellung von Bauteilen, insbesondere Bauteilen von Strömungsmaschinen, wie Flugzeugtriebwerken, wobei zur Herstellung des Bauteils (1) zumindest teilweise ein generatives Verfahren verwendet wird,
**dadurch gekennzeichnet, dass**
mindestens ein Oberflächenbereich (3) des generativ hergestellten Teils des Bauteils (1) mit einer Glättungsschicht (2) versehen wird, die durch Dampfphasenabscheidung abgeschieden wird.

2. Verfahren nach Anspruch 1,
**dadurch gekennzeichnet, dass**
das generative Herstellverfahren einen schichtweisen Aufbau des Bauteils (1) aus Pulvermaterial umfasst, das zu einem festen Bauteil (1) gefügt wird, wobei das Verfahren, insbesondere ausgewählt ist aus einer Gruppe, die selektives Laserschmelzen, selektives Elektronenstrahlschmelzen, selektives Lasersintern, selektives Elektronenstrahlsintern und Pulverauftragsschweißen umfasst.

3. Verfahren nach einem der vorhergehenden Ansprüche,
**dadurch gekennzeichnet, dass**
das gesamte Bauteil (1) generativ hergestellt wird und/oder der gesamte generativ hergestellte Bauteilbereich mit einer Glättungsschicht (2) versehen wird.

4. Verfahren nach einem der Ansprüche 1 bis 2,
**dadurch gekennzeichnet, dass**
nur ein Teil des Bauteils, insbesondere Strömungsflächen mit der Glättungsschicht (2) versehen werden.

5. Verfahren nach einem der vorhergehenden Ansprüche,
**dadurch gekennzeichnet, dass**
die Gasphasenabscheidung ausgewählt ist aus der Gruppe, die physikalische Gasphasenabscheidung, chemische Gasphasenabscheidung, thermisches Verdampfen, Elektronenstrahlverdampfung, Laserstrahlverdampfung, plasmaunterstützte Gasphasenabscheidung und plasmaunterstützte chemische Gasphasenabscheidung umfasst.

6. Verfahren nach einem der vorhergehenden Ansprüche,
**dadurch gekennzeichnet, dass**
die Glättungsschicht mit einer Dicke von 5 µm bis 200 µm, insbesondere 10 µm bis 100 µm aufgebracht wird.

7. Verfahren nach einem der vorhergehenden Ansprüche,
**dadurch gekennzeichnet, dass**
die Glättungsschicht (2) aus einem Material mit einem oder mehreren chemischen Elementen aus dem Grundwerkstoff des zu beschichtenden Bauteils (1) gebildet wird.

8. Verfahren nach einem der vorhergehenden Ansprüche,
**dadurch gekennzeichnet, dass**
die Glättungsschicht (2) aus einem reinen Metall oder einer Legierung oder einer chemischen Verbindung gebildet wird.

9. Verfahren nach einem der vorhergehenden Ansprüche,
**dadurch gekennzeichnet, dass**
das Bauteil (1) mit der Glättungsschicht (2) einer Wärmebehandlung, insbesondere einer Diffusionsglühung, unterzogen wird.

10. Verfahren nach einem der vorhergehenden Ansprüche,
**dadurch gekennzeichnet, dass**
auf der Glättungsschicht (2) eine weitere Funktionsschicht (6) abgeschieden wird.

11. Bauteil einer Strömungsmaschine, insbesondere eines Flugzeugtriebwerks, welches zumindest teilweise generativ hergestellt ist, insbesondere nach dem Verfahren nach einem der vorhergehenden Ansprüche,
**dadurch gekennzeichnet, dass**
mindestens ein Oberflächenbereich (3) des generativ hergestellten Bereichs des Bauteils (1) eine Glättungsschicht (2) aufweist.

12. Bauteil nach Anspruch 11,
**dadurch gekennzeichnet, dass**
das Bauteil (1) ausgewählt ist aus der Gruppe, die Strömungskanalbegrenzungen, Laufschaufeln und Leitschaufeln umfasst und/oder dass das Bauteil (1) als Grundwerkstoff eine Legierung aus der Gruppe aufweist, die Nickel - Basislegierungen, Nickel - Basis - Superlegierungen, Eisen - Legierungen, Titan - Legierungen und Kobalt - Legierungen umfasst.

13. Bauteil nach einem der Ansprüche 11 oder 12,
**dadurch gekennzeichnet, dass**
das Bauteil aus einer Nickel - Basislegierung gebildet ist und die Glättungsschicht (2) aus Aluminium oder Nickel gebildet ist.

14. Bauteil nach einem der Ansprüche 11 bis 13,
**dadurch gekennzeichnet, dass**
die Glättungsschicht (2) eine mittlere Rauheit Rₐ kleiner oder gleich 10 µm, insbesondere kleiner oder gleich 5 µm aufweist.

15. Bauteil nach einem der Ansprüche 11 bis 14,
**dadurch gekennzeichnet, dass**
die Glättungsschicht (2) eine Diffusionsschicht (5a,5b) umfasst.
